# EUROPEAN PATENT APPLICATION

(11) **EP 1 944 805 A1**
(43) Date of publication of application: **16.07.2008**
(21) Application number: 07018260.5
(22) Date of filing: 18.09.2007
(51) Int. Cl.: H01L 27/146

(54) **Solid-state imager and solid-state imaging device**

(30) Priority: 12.01.2007 JP 2007004429
(71) Applicant: Kabushiki Kaisha Toshiba, Minato-ku, Tokyo 105-8001 (JP)
(72) Inventor: Iida, Yoshinori, Minato-ku Tokyo (JP); Funaki, Hideyuki, Minato-ku Tokyo (JP); Honda, Hiroto, Minato-ku Tokyo (JP); Fujiwara, Ikuo, Minato-ku Tokyo (JP)
(74) Representative: HOFFMANN EITLE

(57) **Abstract**

There is provided a single-chip color solid-state imager of a backside illumination type having high sensitivity and low noise that facilitates the miniaturization of a pixel size. A pixel readout circuit is selectively disposed on a part of pixels of a readout block consisting of a plurality of pixels that share the pixel readout circuit.

## Description

### BACKGROUND OF THE INVENTION

### Field of the Invention

The present invention relates to a solid-state imager and a solid-state imaging device.

### Related Art

Due to the diffusion of digital cameras, camera-mounted mobile phones and the like in recent years, demands for solid-state imagers have been increased. In particular, demands for CMOS solid-state imagers that can be manufactured using a CMOS process, which is an ordinary semiconductor manufacturing process, have been increased. In recent years, further down sizing and larger numbers of pixels mounting have been required to such solid-state imagers, and the miniaturization of pixel sizes causes an important problem.

That is, compared with the reduction of plane size parallel to the surface of a semiconductor substrate accompanying the miniaturization of pixels, the reduction in the depth direction vertical to the surface of a semiconductor substrate has not been scaled at the same time, and problems caused thereby have been actualized.

Specifically, since the distance between the surface of the silicon substrate on which a photodiode is formed and the micro lens for optically expanding the aperture ratio is not reduced even if the size of the pixel region in the horizontal direction is reduced, a phenomenon known as "eclipse" or "vignetting" wherein a part of incident light is reflected by a metal wiring layer in the peripheral portion of the pixel region where incident light from the imaging lens diagonally enters occurs in the peripheral portion of the pixel region, and the non-uniformity of sensitivity is caused.

If a circuit design using the latest CMOS process is to be mounted in the peripheral circuit to realized "system on chip", which is the feature of the CMOS solid-state imager, the distance between the surface of the silicon substrate and the micro lens expands due to multilayer wiring in the CMOS process, and the above-described "eclipse" or "vignetting" is more easily occurs.

As a device configuration to cope with such situations, the development of a CMOS sensor of backside illumination type has been reported (for example, refer to JP-A No. 2003-31785 (KOKAI), or S. Iwabuchi, et. al., ISSCC Tech. Digest, pp. 302-303, 2006).

However, when long-wavelength light wherein the absorption coefficient of the silicon substrate is low, and the penetration length of incident light is large was imaged, there was a problem wherein the incident light passes through the rear surface side photodiode, reaches the surface side readout circuit region, and the operation of the readout circuit is modulated by electron-hole pairs generated there. Consequently, the photodiode formed on the rear surface side could not be designed to be sufficiently large, and the effect of improving the aperture ratio of the photodiode by back-face was insufficient.

For example, when visible light having wavelengths of 400 nm to 700 nm, the absorption coefficient of single-crystalline silicon to long wavelength (700 nm) light is as low as 2192 cm⁻¹, and the transmittance to a silicon substrate having a thickness of 4 µm, shown in S. Iwabuchi, et. al., ISSCC Tech. Digest, pp. 302-303, 2006 is as high as 40%. Even if long-wavelength components of 650 nm or more are removed by an IR cut filter, the absorption coefficient of single-crystalline silicon to 650 nm light is as low as 3162 cm⁻¹, and the transmittance to a silicon substrate having a thickness of 4 µm is nearly 30%.

Therefore, in order to prevent the effect of the above-described transmitted light, instead of the structure described in Patent Document 1, the solid-state imager is designed so that the readout circuit in the surface side does not overlap the photodiode in the backside (e.g., S. Iwabuchi, et. al., ISSCC Tech. Digest, pp. 302-303, 2006).

Specifically, the effect to improve the aperture ratio of the backside photodiode, or the effect to expand the area of the surface side readout circuit is not fully obtained.

### SUMMARY OF THE INVENTION

Considering the above-described situations, the present invention provides a high-sensitivity and low noise color solid-state imager of a backside illumination type wherein the miniaturization of pixel size is easy.

A solid-state imager according to a first aspect of the present invention includes: a semiconductor substrate; a pixel region formed by arranging pixels in a matrix form on the semiconductor substrate, the pixel region including photoelectric converting portions, a transfer transistor provided in each of the photoelectric converting portions, and pixel readout circuits disposed in a surface side of the semiconductor substrate opposite from the backside receiving the incident light, each of the pixel readout circuit being selectively disposed in a part of a readout block consisting of a plurality of the pixels that share the pixel readout circuit; a readout portion configured to read electrical signals from the pixels; and a color filter array provided on a backside receiving an incident light in the pixel region, and formed by repetitively disposing a plurality of unit blocks corresponding to the pixels.

A solid-state imaging device according to a second aspect of the present invention includes: the solid-state imager according to the first aspect; an optical lens system configured to condense incident light and image the condensed light on the solid-state imager; and a signal processing portion configured to process electrical signals outputted from the solid-state imager.

### BRIEF DESCRIPTION OF THE DRAWINGS

FIG. 1 is a block diagram for illustrating the chip configuration of a solid-state imager according to an embodiment of the present invention;
FIGS. 2A to 2C are diagrams showing examples of primary-color system color filter arrays that include 2×2 pixel blocks as unit blocks;
FIGS. 3A and 3B are plan views for illustrating the 2 × 2 pixel blocks in a solid-state imager according to an embodiment in the surface side and the backside;
FIG. 4 is a circuit diagram for illustrating the circuit in a 2 x 2 pixel block in a solid-state imager according to an embodiment;
FIG. 5 is a cross-sectional structure diagram for illustrating the cross-sectional structure of a B (blue) pixel in a solid-state imager according to an embodiment;
FIG. 6 is a cross-sectional structure diagram for illustrating the cross-sectional structure of a G (green) pixel and an R (red) pixel in a solid-state imager according to an embodiment;
FIG. 7 is a diagram showing the absorption coefficient of monochromatic light in single crystal silicon;
FIG. 8 is a graph for illustrating the absorption of monochromatic light in single crystal silicon;
FIG. 9 is a layout diagram for illustrating the layout of a 4 x 4 pixel block in a solid-state imager according to an embodiment of the present invention;
FIGS. 10 to 12 are layout diagrams for illustrating the layout of a 4 x 4 pixel block in a solid-state imager according to an embodiment of the present invention;
FIGS. 13 to 19 are cross-sectional structure diagrams of B pixels for illustrating the process for manufacturing a solid-state imager according to an embodiment of the present invention;

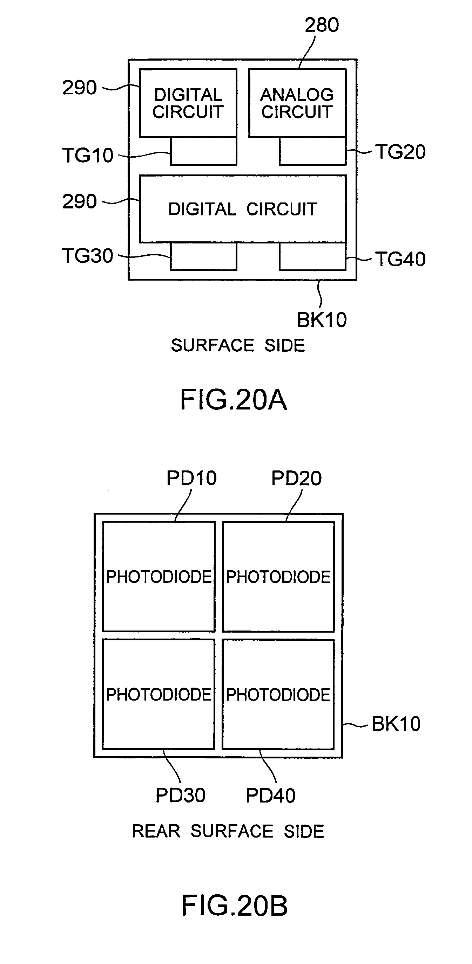

FIGS. 20A and 20B are plan views when the analog circuit portion and the digital circuit portions are separately disposed in a solid-state imager according to an embodiment of the present invention;
FIG. 21 is a circuit diagram for illustrating the circuit in the pixel of a 2 x 1 pixel block in another solid-state imager according to an embodiment of the present invention;
FIGS. 22 to 25 are layout diagrams for illustrating the layout of another 4 x 4 pixel block in a solid-state imager according to an embodiment of the present invention; and
FIG. 26 is a basic block diagram showing the configuration of a solid-state imaging device.

### DETAILED DESCRIPTION OF THE INVENTION

Embodiments of the present invention will be described in detail referring to the drawings. In the drawings shown below, the same parts will be denoted by the same numerals or characters, and repetitive description thereof will be omitted. The drawings are schematic, and the relation between thickness and planar dimensions, the thickness ratio of each layer, and the like are different from actual ones. Furthermore, some drawings contain parts having relations or ratios different from those in other drawings.

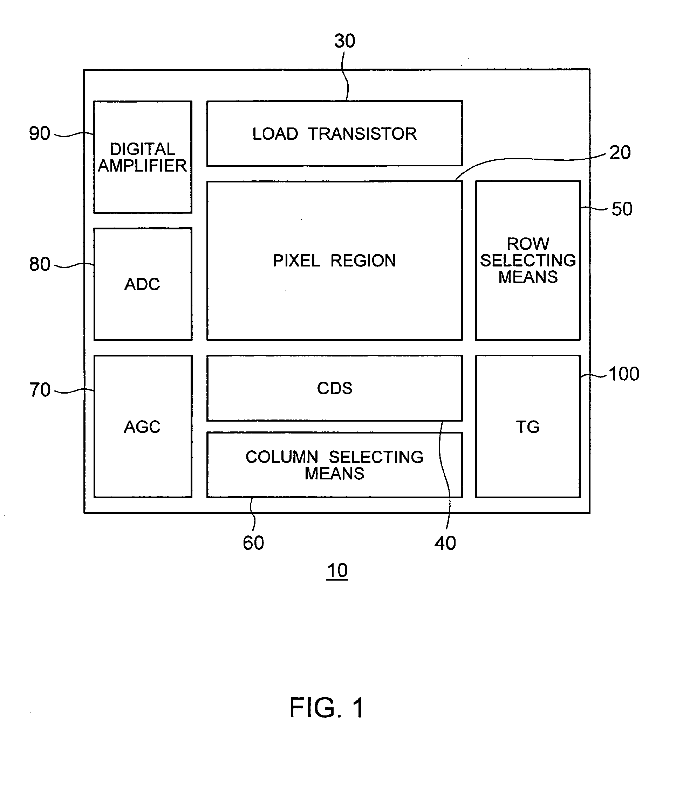

FIG. 1 is a block diagram for illustrating the schematic configuration of a solid-state imager 10 according to an embodiment of the present invention.

The solid-state imager 10 is formed by arranging a load transistor 30, a CDS (correlation double sampling) circuit section 40, row selection means 50, column selection means 60, an AGC (automatic gain control circuit) 70, an ADC (A/D converter) 80, a digital amplifier 90, a TG (timing generator) circuit 100 and the like around a pixel region 20 (pixel region section) wherein pixels to convert incident light signals into electrical signals by photoelectric conversion are two-dimensionally arrayed. At least the V selection means 50 and the H selection means 60 configure readout means for reading electrical signals from each pixel.

The ADC 80 may be integrally formed with the CDS circuit section 40 to be a column-parallel CDS-ADC circuit configuration.

Alternatively, the TG circuit 100, the AGC 70, the ADC 80, the digital amplifier 90 or the like may be formed in a separate chip, and a signal processing circuit not shown in FIG. 1 may be mounted.

In the pixel region 20 shown in FIG. 1, on-chip color filters (CF) having different spectral transmission factors for each pixel are formed to configure a single-chip color solid-state imager.

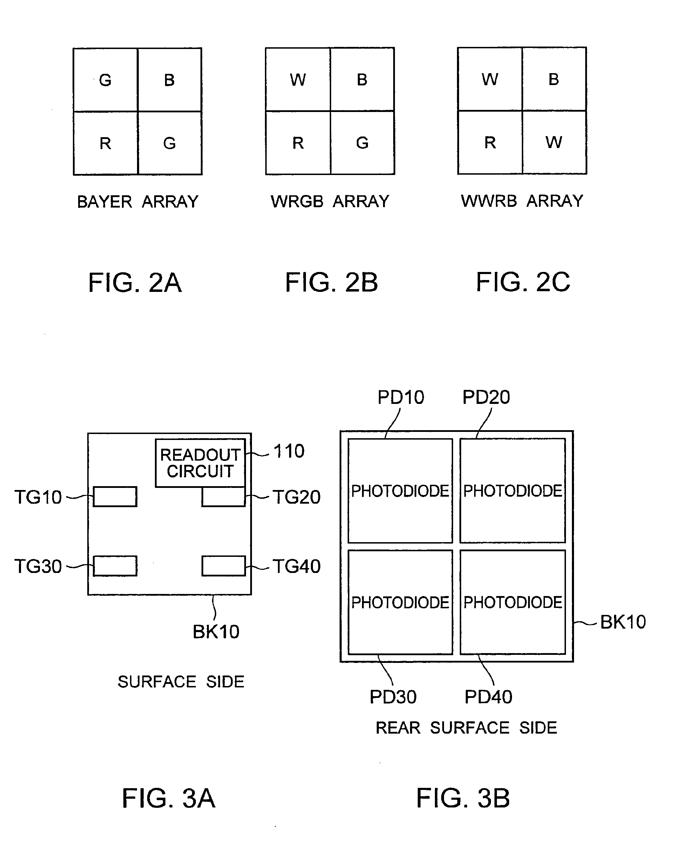

The array of CF can be of 2 x 2 pixel block configuration as shown in FIGS. 2A to 2C, such as Bayer array (FIG. 2A), which is a general primary-color CF array, WRGB array (FIG. 2B), and WWRB array (FIG. 2C). In FIGS. 2A to 2C, G denotes a G pixel having a CF that transmits green, B denotes a B pixel having a CF that transmits blue, R denotes an R pixel having a CF that transmits red, and W denotes a W pixel having a transparent layer that transmits all the light in the visible-light region.

The array of CF can also be of pixel block configurations larger than 2 x 2 pixel blocks shown in FIGS. 2A to 2C, or a complementary color CF can be used instead of primary color CF.

As described above, the array of CF (color filter array) is provided in the incident-light side of the pixel region 20, a block corresponding to a plurality of pixels is made to be a unit block, and the pixel region 20 is formed by repetitively disposing the unit blocks.

In descriptions hereafter, an example using the Bayer array, shown in FIG. 2A as the CF array, will be described.

FIGS. 3A and 3B are schematic configuration diagrams for illustrating the pixel sections in a 2 x 2 pixel block BK10 wherein Bayer array CFs are formed, and shows the configuration in the pixels on the surface side (FIG. 3A) which is the side opposite to the incident surface of incident light, and on the rear surface side (FIG. 3B) which is the incident surface of incident light. As can be seen from the comparison with FIGS. 2A to 2C, it is characterized that the readout circuit 110 in the surface side (i.e., pixel readout circuit) is formed only on the B pixel.

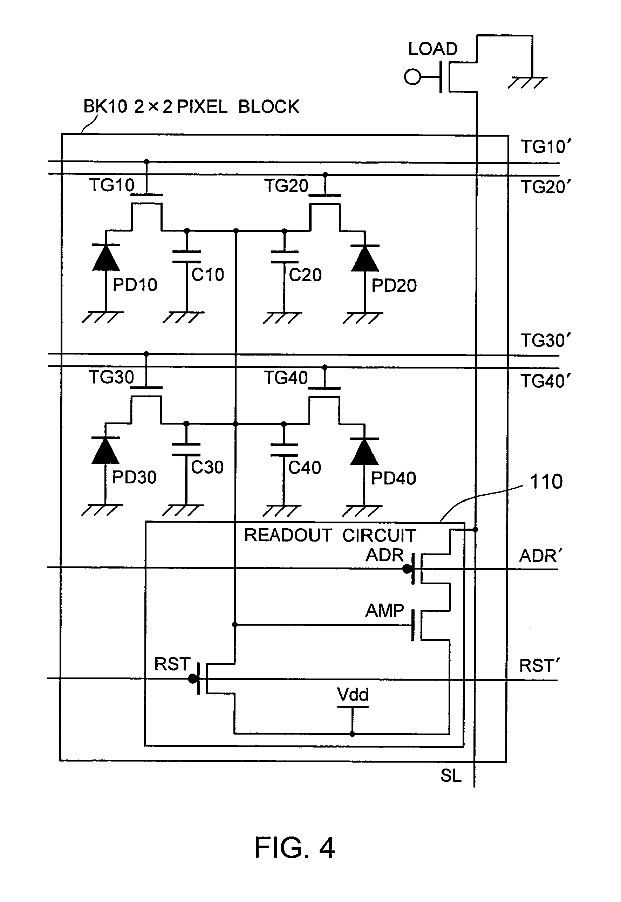

FIG. 4 is a circuit diagram for illustrating an example of the circuit in a pixel of a 2 x 2 pixel block BK10 (readout block). In the pixel block BK10 consisting of four pixels, four photodiodes (photoelectric conversion section) PD10 to PD40, four transfer transistors TG10 to TG40, and a readout circuit 110 are included. C10 to C40 denote storage capacitors.

The readout circuit 110 is configured by a reset transistor RST that resets signal charges transferred by the transfer transistors TG10 to TG40, an amplifying transistor AMP that generates signal voltages corresponding to the signal charges on a signal line SL, and a selecting transistor ADR for activating the readout circuit 110 in the row selected by the row selecting pulse.

The amplifying transistor AMP in the readout circuit 110 configures a source follower circuit by the combination with a load transistor LOAD that forms a load transistor section 30 disposed out of the pixel region 20, and in rows not selected by the selecting transistor ADR, the source follower circuit is isolated from the power voltage Vdd and inactivated.

Therefore, the selecting transistor ADR and the amplifying transistor AMP are not limited to the arrangement shown in FIG. 4, but their locations can be exchanged as long as they are connected in series.

By devising the operation timing of the reset transistor RST and setting the gate potential of the amplifying transistor AMP in the non-selected row to Vss, the source follower circuit can be inactivated, and in this case, the selecting transistor ADR can be omitted.

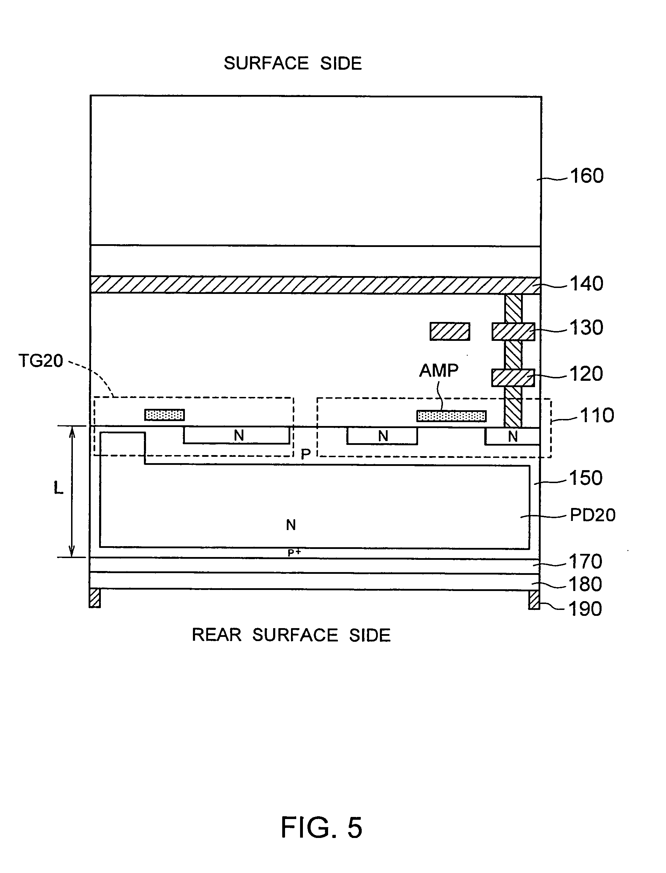

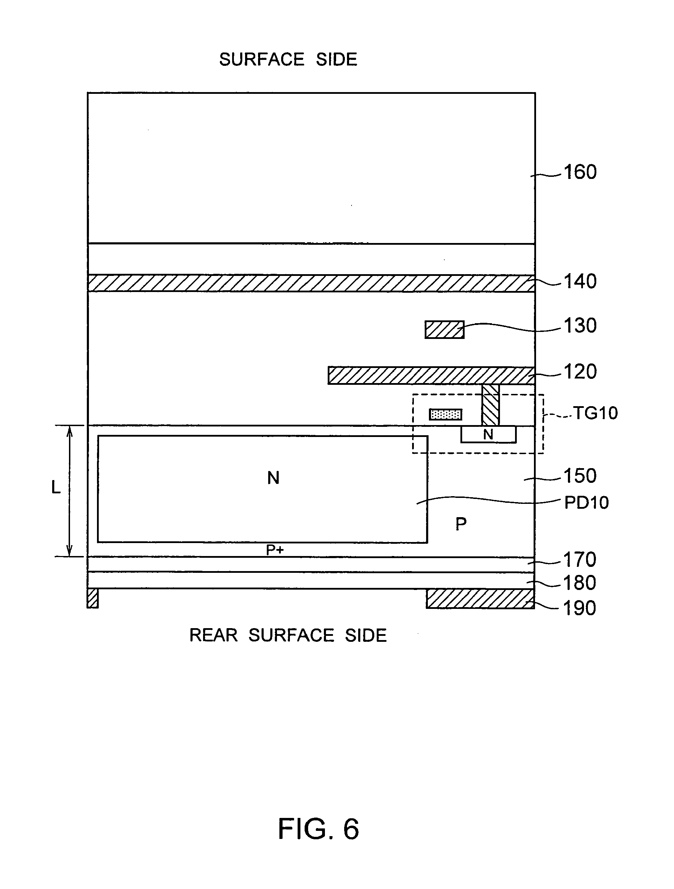

FIGS. 5 and 6 are cross-sectional structure diagrams of backside illuminated pixels wherein incident light is radiated from the backside, which is the lower side of the drawings.

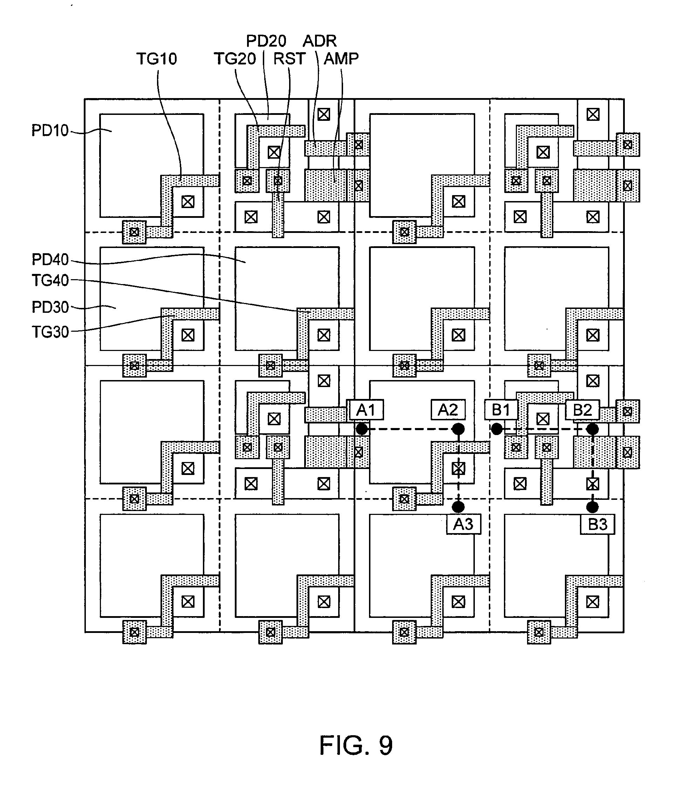

FIG. 5 is a cross-sectional structure diagram of a B pixel, and FIG. 6 is a cross-sectional structure diagram of a G pixel (R pixel). FIG. 5 shows a vertical cross-sectional view along the line B1-B2-B3 in FIG. 9 that shows the layout of a 4 x 4 pixel block, and FIG. 6 shows a vertical cross-sectional view along the line A1-A2-A3 in FIG. 9.

As seen from the comparison of FIG. 5 and FIG. 6, the readout circuit 110 in the surface side of the substrate is formed only in the B pixel of FIG. 5, and the readout circuit 110 is not formed in the surface side in the G pixel and the R pixel of FIG. 6.

A process for obtaining sectional structures shown in FIGS. 5 and 6 will be described below.

An impurity structure, a gate structure, and a multilayer wiring structure (first metal layer 120, second metal layer 130, and third metal layer 140) in a silicon substrate (semiconductor substrate) are formed by carrying out an ordinary CMOS image sensor manufacturing process using, for example, an SOI (Silicon On Insulator) substrate on the surface side of the SOI layer 150 (semiconductor substrate).

After the surface-side structure has been formed, a supporting substrate 160, such as a glass substrate, is bonded on the surface side.

After the supporting substrate 160 has been bonded, by a process, such as mechanical polishing, BSG (Back-Side Grinding), CMP (Chemical Mechanical Polishing), silicon dry etching, silicon wet etching, and the combination thereof, the bulk substrate (not shown) of the SOI substrate is removed from the rear surface side to expose the SiO₂ layer 170 on the back face, which is the light incident side.

Furthermore, as required, a thin high-concentration P+ region can be formed on the rear surface side of the silicon layer in the light incident side (SOI layer 150). It is more preferable that the depletion layer formed by photodiodes PD10 to PD40 is isolated from the silicon layer/silicon dioxide film interface (SOI layer 150/SiO₂ layer 170) to obtain lower dark current.

Thereafter, an SiN layer 180 is formed for the refection preventing structure in the rear surface side, and the light-shielding layer 190 is formed.

For bonding pads (not shown), pad openings penetrating the supporting substrate 160 on the surface side may be formed. Alternatively, pad openings penetrating the SiN layer 180, the SiO₂ layer 170, the SOI layer 150, and the multilayer wiring layer may be formed on the rear surface side.

After a monochromatic imager has been fabricated by the above-described process, CF and on-chip micro lens are formed on the rear surface side.

It is important that the thickness L of the SOI layer 150 shown in FIGS. 5 and 6 is larger than the penetration length P of the incident light having a wavelength of λ into the silicon substrate.

Thereby, the penetration of the incident light that entered from the backside into the readout circuit 110 to make circuit operation unstable can be avoided.

The penetration length P is preferably defined as the depth P (99%) where absorption in the silicon substrate is 99%, and more preferably defined as the depth P (99.9%) where absorption in the silicon substrate is 99.9%.

For example, in blue light having λ of about 450 nm, P (99%) and P (99.9%) are 1 µm to 2 µm and 3 µm to 4 µm, respectively.

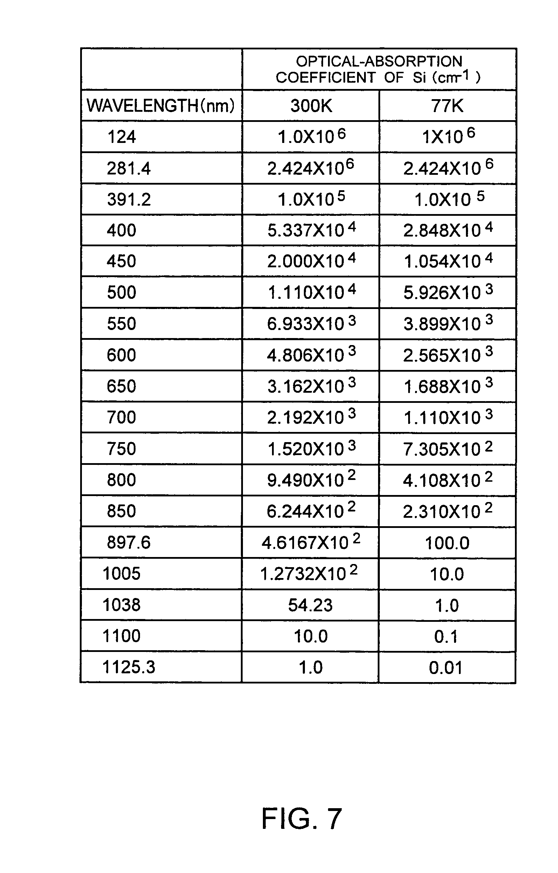

The absorption coefficient α of monochromic light in single-crystalline silicon had wavelength dependence as shown in FIG. 7, and the absorption coefficient α lowers as the wavelength λ increases.

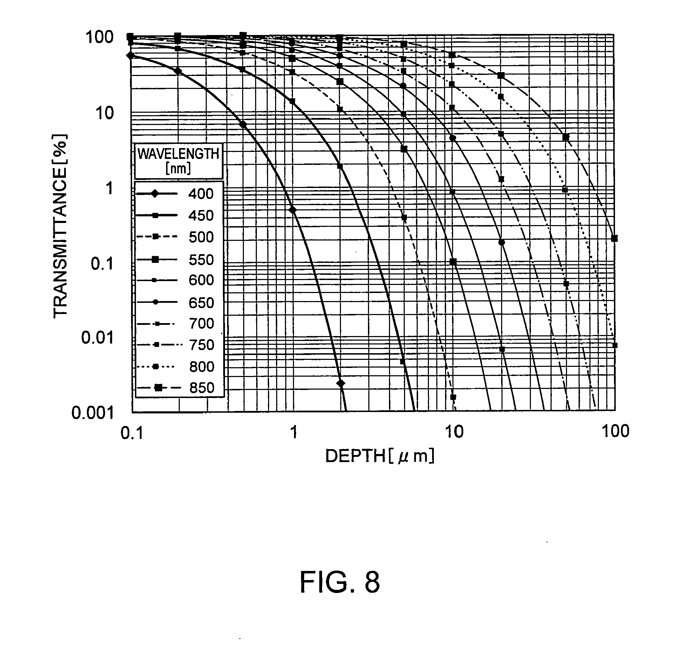

FIG. 8 shows the results of calculating the depth of single-crystalline silicon and the transmittance of monochromatic light for monochromatic light having a wavelength λ of 400 nm to 850 nm using the absorption coefficients at T = 300 K (room temperature) shown in FIG. 7.

When incident light having a wavelength λ of 650 nm, which is blocked by a IR (infrared) cut filter is considered as the upper limit of the wavelengths of red light passing through the CF formed in R pixels, the penetration length P (99%) and P (99.9%) are up to 15 µm and 21 µm, respectively.

When incident light having a wavelength λ of 550 nm is considered as green light passing through the CF formed in G pixels, the penetration length P (99%) and P (99.9%) are 7 µm and 10 µm, respectively.

On the other hand, the thickness L of the SOI layer 150 is restricted by the thickness of the N layer of the photodiode for completely reading the signal charge accumulated in the photodiode PD, and the thickness of the P⁺ layer of the photodiode on the rear surface side for transferring and accumulating the signal charge generated by the absorption of short-wavelength light in the photodiode, which is normally several micrometers.

Therefore, in red light and green light incident into R pixels and G pixels, absorption in photodiodes PD10, PD30 and PD40 formed on the SOI layer 150 having a thickness of several micrometers is insufficient, and light that has passed through the photodiodes PD10, PD30 and PD40 reaches the surface side of the SOI layer 150.

If the light that has passed through the photodiodes PD penetrates the readout circuit 110 in the surface side of the SOI layer 150, the operation of the readout circuit 110 becomes unstable due to the electron-hole pair generated by light absorption in the readout circuit 110. Therefore, in the above-described Non-patent Document 1, the photodiode in the rear surface side must be inevitably disposed so as not to be stacked with the readout circuit in the surface side, the aperture ratio of the photodiode cannot be sufficiently expanded, and the area of the readout circuit is limited.

On the other hand, according to the present embodiment, the readout circuit 110 is formed only in the surface side of the B pixels as shown in FIGS. 2, 3, 5 and 6, and not in the surface sides of the G pixels and R pixels. Therefore, the operation of the readout circuit 110 becoming unstable because red light and green light pass through the photodiodes PD10, PD30 and PD40 as described above can be avoided. At the same time, in the B pixels, the photodiode opening in the rear surface side can be designed to be largest as shown in FIG. 5, and the effect of improving the blue color sensitivity can be obtained. Similarly, since the readout circuit 110 is not present in R pixels and G pixels, what limit the photodiode opening are only the transferring transistors TG10, TG30 and TG40, and the photodiode opening can be expanded. Therefore, the effect of improving red color sensitivity and green color sensitivity can also be obtained.

Furthermore, since the most part of the surface side of the B pixels can be used as the readout circuit 110, not only the miniaturization of pixels can be easily designed, but also the size of the amplifying transistor AMP, which is a noise source of the readout circuit 110 can be enlarged, and the effect of lowering the 1/f noise generated in the amplifying transistor AMP can also be obtained.

FIGS. 9 to 12 show the layout of a 4 x 4 pixel block that has the circuit configuration shown in FIG. 4 as an example of surface-side layout when a Bayer array CF of the 2 x 2 pixel block shown in FIG. 2.

FIG. 9 shows the structures of the active regions, gates and contacts. In R pixels and G pixels, only photodiodes PD10, PD30 and PD40 formed to the vicinity of the surfaces, and transferring transistors TG10, TG30 and TG40 are formed; and in B pixels, readout circuits 110 (reset transistors RST, amplifying transistors AMP and selection transistors ADR) are formed in addition to photodiodes PD20, and transferring transistors TG20.

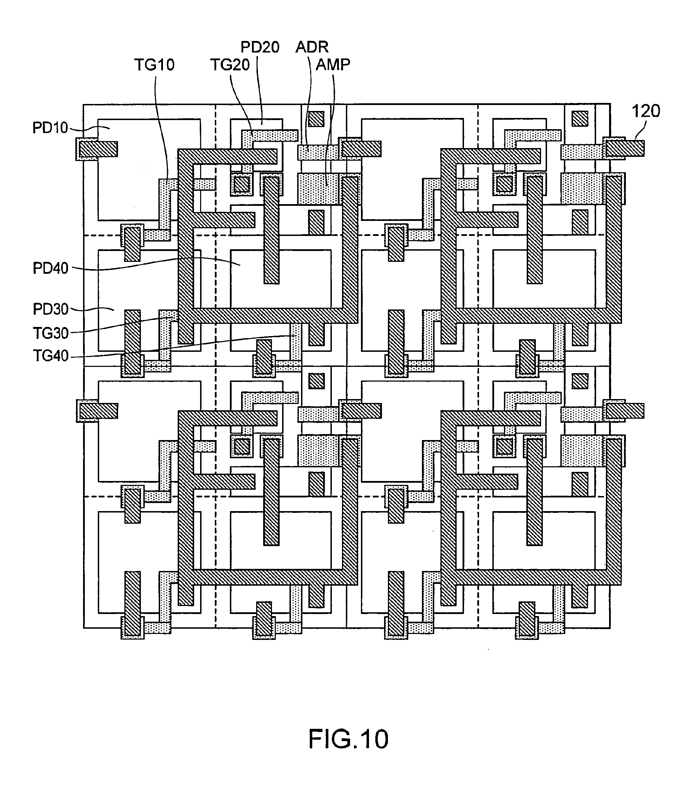

In FIG. 10, first metal layer 120 patterns are additionally shown on the patterns shown in FIG. 9.

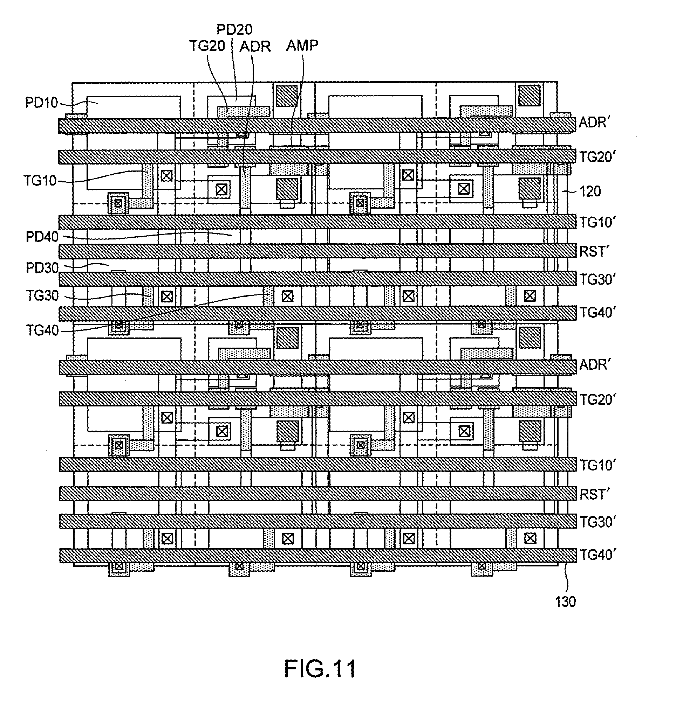

In FIG. 11, the first metal layer 120 patterns shown in FIG. 10 are outlined, and second metal layer 130 patterns are additionally shown on the patterns shown in FIG. 10.

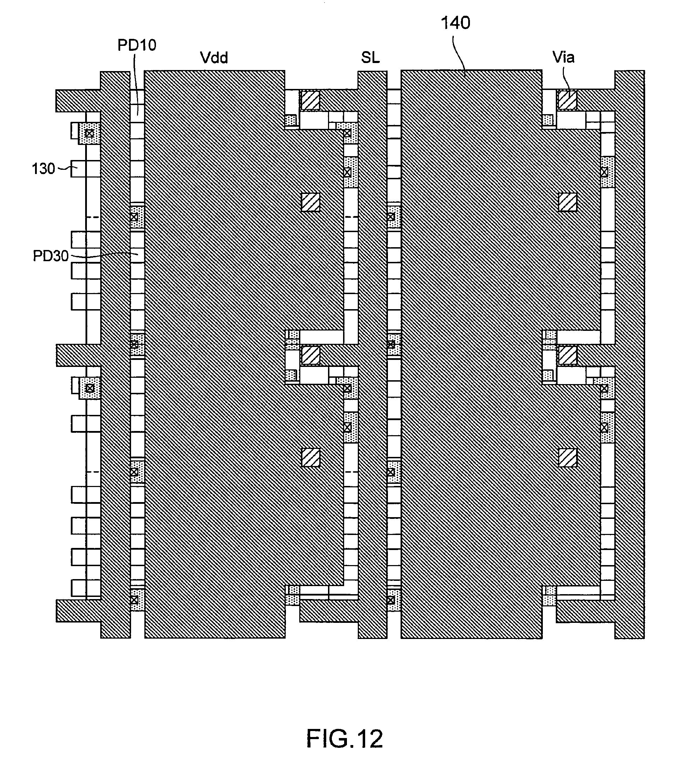

In FIG. 12, the second metal layer 130 patterns shown in FIG. 11 are outlined, and third metal layer 140 patterns are additionally shown on the patterns shown in FIG. 11.

In the metal layer patterns shown in FIGS. 10 to 12, the first metal layer 120 are used for wirings in the 2 x 2 pixel block, the second metal layer 130 are used for global horizontal wirings, and the third metal layer 140 are used for global vertical wirings.

As described above, according to the present embodiment, the miniaturization of pixels can be easily designed, and a single-chip color solid-state imager of a backside illumination type having high sensitivity and low noise can be obtained.

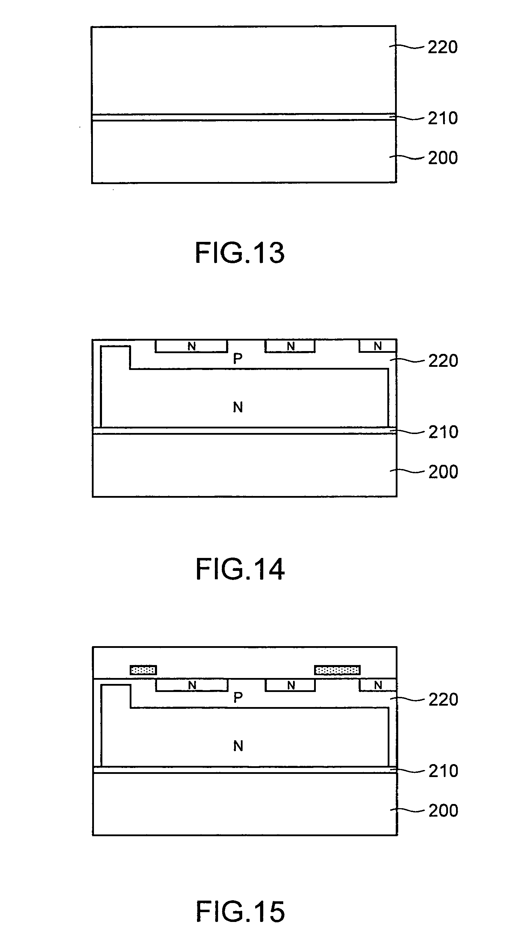

FIGS. 13 to 19 show the process for manufacturing a solid-state imager 10 according to the present embodiment. (As cross-sectional structure, the structure of a blue pixel is used.)

For example, using an SOI substrate consisting of a bulk silicon substrate 200, a BOX layer 210 and an SOI layer 220 (FIG. 13), desired impurity structure can be formed on the SOI layer 220 as shown in FIG. 14 by appropriately combining photolithography, ion implantation and activation process.

Next, MOS transistors are formed by an ordinary CMOS process (FIG. 15).

Actually, it will be obvious that a self-aligned impurity region used in the ordinary CMOS process can be formed, and for example, after forming a gate electrode, ion implantation is performed using the gate electrode as a part of a mask to obtain the structure shown in FIG. 15.

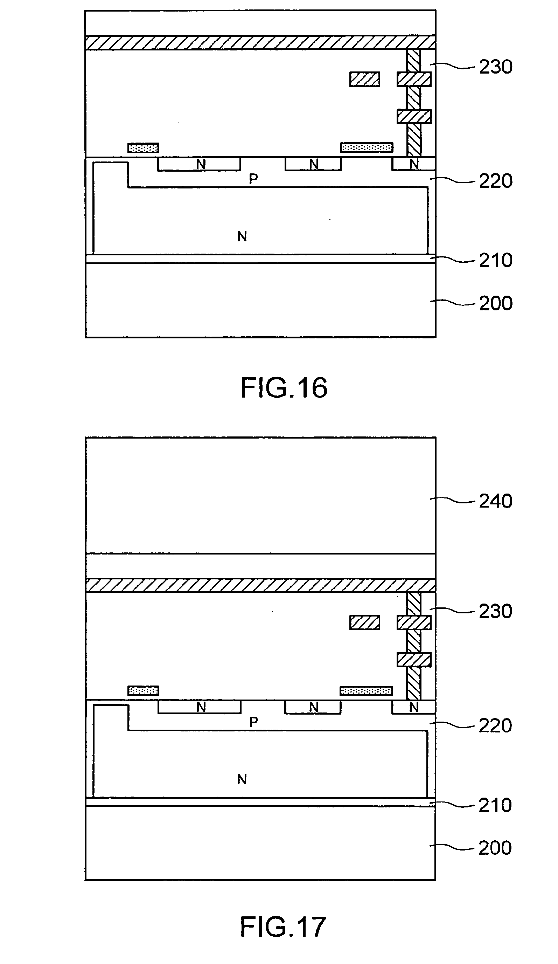

Furthermore, a multiple metallization layer 230 is formed by an ordinary multiple metallization process to obtain the structure shown in FIG. 16.

Then, for example, as a supporting substrate 240 a single-crystalline silicon substrate or the like is bonded on the surface side of the substrate (FIG. 17).

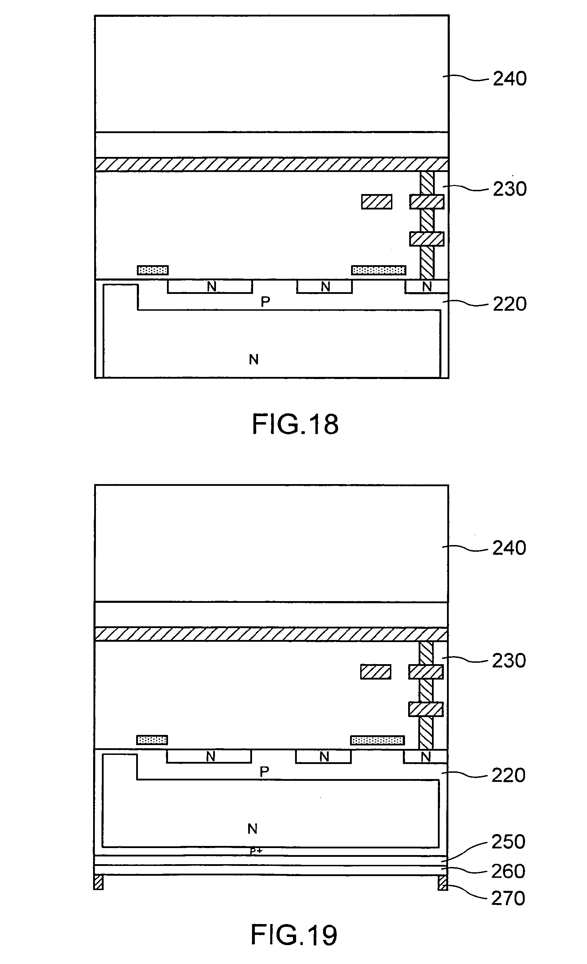

Next, using the combination of grinding, chemical-mechanical polishing, wet etching, dry etching or the like to remove the bulk silicon substrate 200 on the rear surface side of the SOI substrate, and the BOX layer 210 is removed (FIG. 18).

Finally, from the rear surface side, a backside P+ region is formed; and an SiO₂ layer 250, an SiN layer 260, and a light shielding layer 270 are formed (FIG. 19).

Although the BOX layer 210 is removed from the structure shown in FIG. 18, the BOX layer 210 may also be left.

In the present embodiment, however, although the readout circuits 110 are formed only in the surface sides of the B pixels, it is preferable to thicken the SOI layer 150 to the 99% penetration length P (99%) of a green light at 550 nm, i.e. 7 µm or more, to enable the readout circuits 110 to be formed on the B pixels and G pixels and in this case, the area of the readout circuits can be further expanded and noise can be lowered.

Furthermore, by forming the readout circuits 110 on the B pixels and G pixels, the circuit scale of the readout circuits 110 can be expended, and circuits in pixels, such as ADC circuits (analog-digital conversion circuits) in pixels, can be formed in the readout circuits 110. In this case, by the A-D conversion of all the pixels in parallel, asynchronism caused by rolling readout, which is a problem in CMOS sensors can be avoided, and imaging that satisfies synchronism can be preferably carried out. The ADC circuit 80 shown in FIG. 1 is not required in this case.

Alternatively, when the ADC circuit 80 is added to the readout circuit 110, only the analog circuit 280 can be formed on the surface sides of B pixels, and the digital circuit 290, which resists noise, can be formed on the surface sides of R pixels and G pixels to achieve the equivalent effect. For example, only capacitors and accompanying wirings or the like required in a latching circuit or the like can be formed on the surfaces of R pixels and G pixels.

In the present embodiment, although the case of a primary-color CF shown in FIGS. 2A to 2C is described, the equivalent effect can be achieved also in the case of using a complementary-color CF by thickening the SOI layer 150 to the 99% penetration length P (99%) of a green light at 550 nm, i.e 7 µm or more, and by forming a surface-side readout circuit 110 only in Cy (cyan) pixels, which are the sum components of green light and blue light, and in G pixels.

### (Other Embodiments)

In the above-described embodiment, although an example wherein a unit block of CF arrays, and a readout block wherein a readout circuit 110 is shared by a plurality of pixels are described, it is not essential that the readout block is identical to the unit block of CF arrays, and the readout block can be optionally designed independently from the unit block of CF arrays.

Here, as another embodiment, for example, the case wherein the unit block of color filters is a 2 x 2 four-pixel block, and the readout block is a 2 x 1 two-pixel block BK100 will be described. The color filters are of Bayer array as in the above-described case.

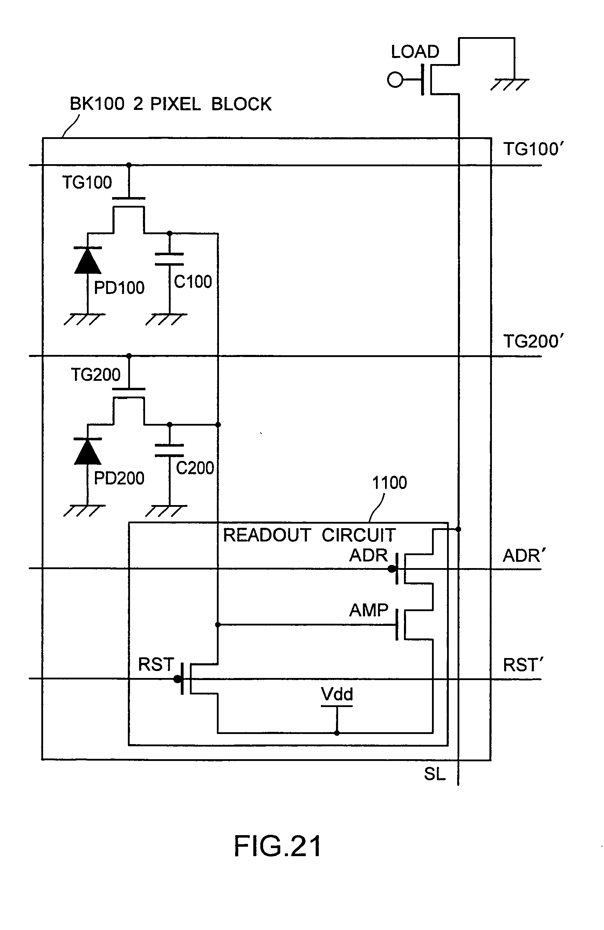

The circuit configuration of the readout block in the other embodiment is shown in FIG. 21, and as in FIG. 4 of the present embodiment, the readout circuit 1100 is shared by two pixels.

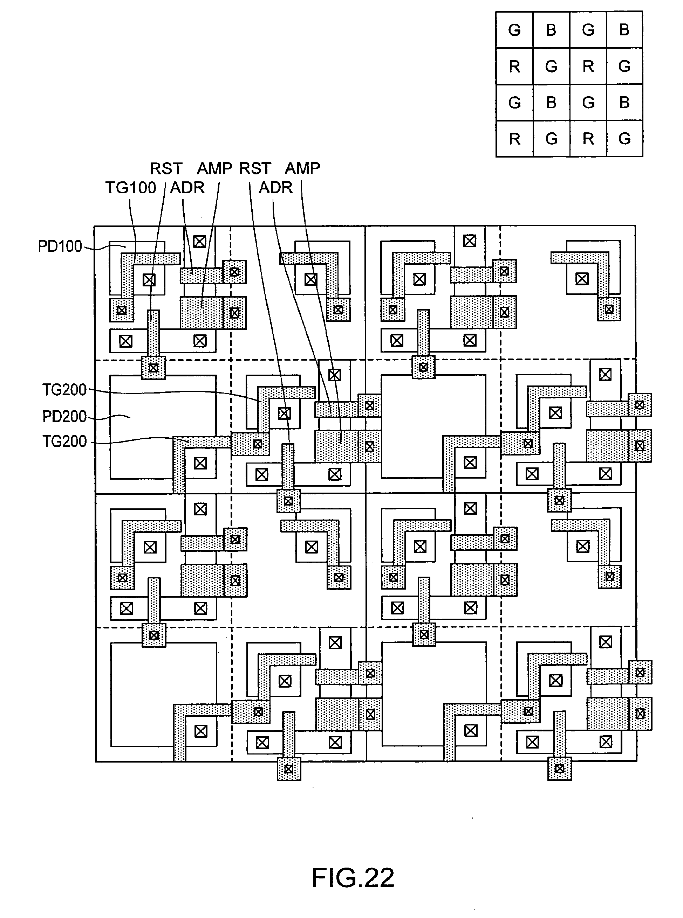

As an example of an actual surface-side layout in the case wherein Bayer-array CF of the 2 x 2 pixel block shown in FIGS. 2A to 2C, the layout of a 4 x 4 pixel block having the circuit configuration shown in FIG. 21 is shown in FIGS. 22 to 25.

In the other embodiment, the readout circuit 1100 is formed on G pixels instead of B pixels.

FIG. 22 shows the structures of the active regions, gates and contacts. In R pixels, only photodiodes PD200 formed to the vicinity of the surfaces, and transferring transistors TG200 are formed; and in G pixels, readout circuits 1100 (reset transistors RST, amplifying transistors AMP and selection transistors ADR) are formed in addition to the readout N regions of photodiodes PD100, and transferring transistors TG100.

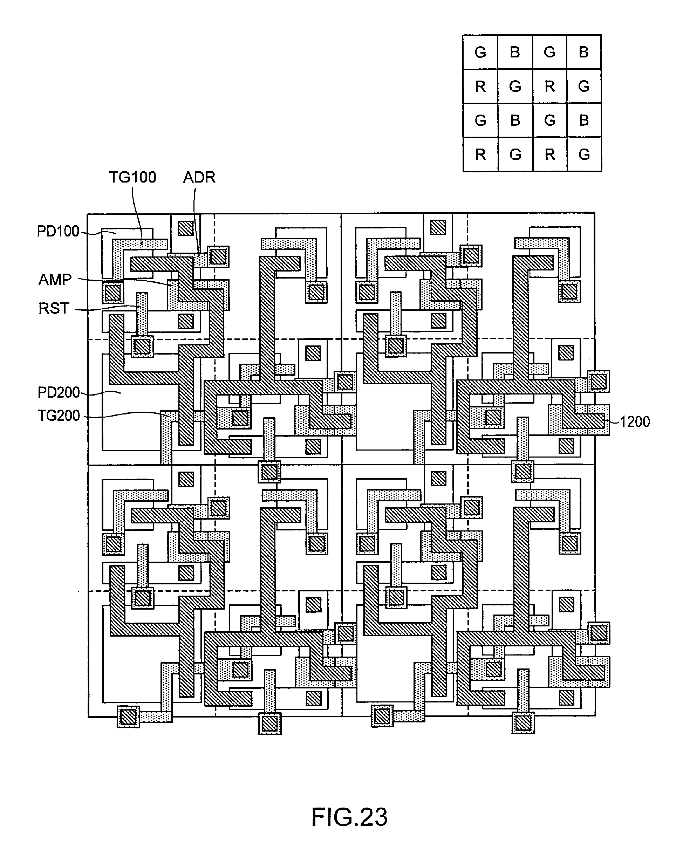

In FIG. 23, first metal layer 1200 patterns are additionally shown on the patterns shown in FIG. 22.

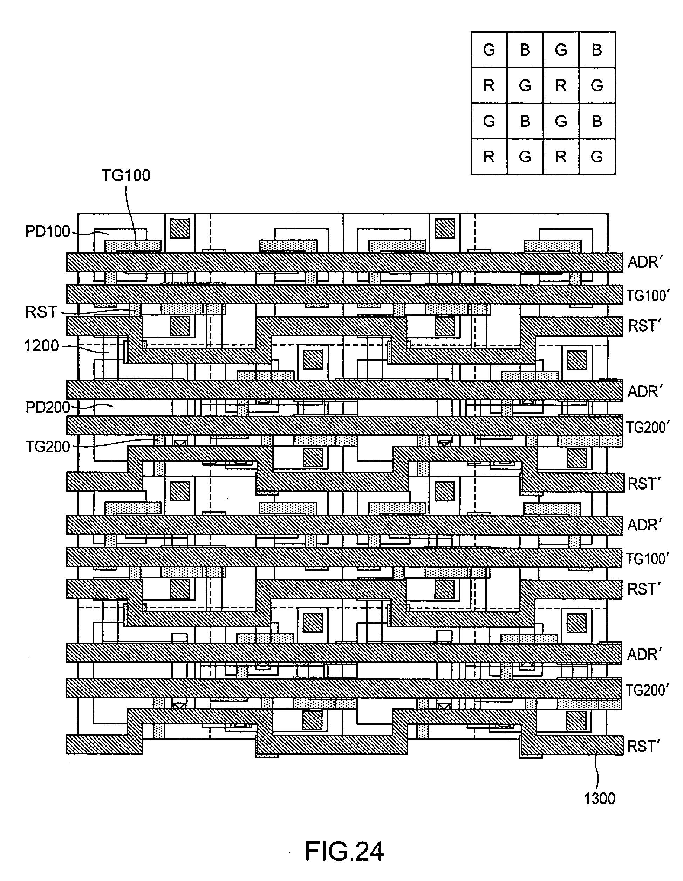

In FIG. 24, the first metal layer 1200 patterns shown in FIG. 23 are outlined, and second metal layer 1300 patterns are additionally shown on the patterns shown in FIG. 23.

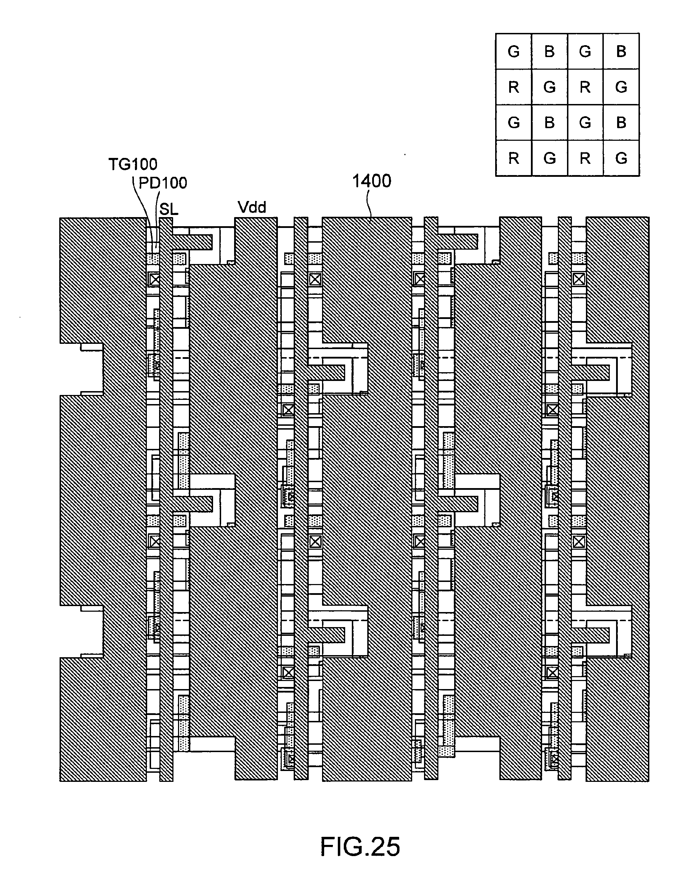

In FIG. 25, the second metal layer 1300 patterns shown in FIG. 24 are outlined, and third metal layer 1400 patterns are additionally shown on the patterns shown in FIG. 24.

In the metal layer patterns shown in FIGS. 23 to 25, the first metal layer 1200 are used for wirings in the 2 x 2 pixel block, the second metal layer 1300 are used for global horizontal wirings, and the third metal layer 1400 are used for global vertical wirings.

Since the process for the solid-state imager is the same as the process in the above-described embodiment, the description thereof will be omitted. It is obvious that the same effects as the effects of the above-described embodiment can be achieved also by the other embodiment.

Furthermore, the CF array is not limited to the 2 x 2 pixel block shown in FIGS. 2A to 2C, but the embodiment can be applied to single-chip color solid-state imagers having other unit blocks, such as the 4 x 2 pixel block and the 4 x 4 pixel block, and the same effects can be achieved.

In a camera module or a solid-state imaging device using the solid-state imager 10 according to the present embodiment, features of small size, low costs and high performance can be obtained by the high-sensitivity characteristics and low noise characteristics of the element, and a ultra fine pixel size.

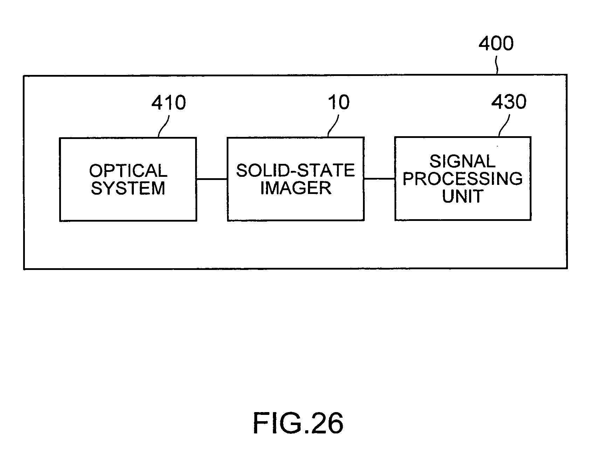

FIG. 26 shows the basic configuration of a solid-state imaging device 400 having the above-described solid-state imager 10. The solid-state imaging device 400 consists of a solid-state imager 10, an optical system 410 and signal processing unit 430 for processing electrical signals outputted from the solid-state imager 10.

The present invention is not limited to the above-described embodiment without modification, but can be embodied in practical phases by modifying the configuring elements within a range not deviating from the concept of the present invention. In addition, by appropriately combining a plurality of configuring elements disclosed in the above-described embodiments, various inventions can be created. For example, certain configuring elements can be deleted from all the configuring elements described in the embodiments. Furthermore, configuring elements across different embodiments may be appropriately combined.

## Claims

1. A solid-state imager comprising:
a semiconductor substrate;
a pixel region formed by arranging pixels in a matrix form on the semiconductor substrate, the pixel region comprising photoelectric converting portions provided on a backside receiving the incident light in the semiconductor substrate, a transfer transistor provided in each of the photoelectric converting portions, and pixel readout circuits disposed in a surface side of the semiconductor substrate opposite from the backside receiving the incident light, each of the pixel readout circuit being selectively disposed in a part of a readout block consisting of a plurality of the pixels that share the pixel readout circuit;
a readout portion configured to read electrical signals from the pixels; and
a color filter array provided on a backside receiving an incident light in the pixel region, and formed by repetitively disposing a plurality of unit blocks corresponding to the pixels.

2. The solid-state imager according to claim 1, wherein the pixel-block sharing the pixel readout circuit is formed by the same pixel group as the unit block.

3. The solid-state imager according to claim 1, wherein the unit block is formed by an RGB primary-color filter.

4. The solid-state imager according to claim 1, wherein the unit block is formed by an RGB primary-color filter and a transparent colorless filter.

5. The solid-state imager according to claim 1, wherein the unit block is formed by two primary-color filters including blue among RGB primary-colors and a transparent colorless filter.

6. The solid-state imager according to claim 1, wherein the pixel readout circuits are selectively disposed in pixels wherein blue color filters are formed.

7. The solid-state imager according to claim 1, wherein the pixel readout circuits are selectively disposed in pixels wherein blue color filters are formed and green color filters are formed.

8. The solid-state imager according to claim 1, wherein the pixel readout circuits include analog-digital conversion circuits.

9. The solid-state imager according to claim 1, wherein the pixel readout circuits include analog circuit portions that form analog-digital conversion circuits, and the analog circuit portions are selectively disposed in a part of pixels among the readout blocks consisting the plurality of pixels.

10. A solid-state imaging device comprising:
the solid-state imager according to any one of claims 1 to 9;
an optical lens system configured to condense incident light and image the condensed light on the solid-state imager; and
a signal processing portion configured to process electrical signals outputted from the solid-state imager.
